# EUROPÄISCHE PATENTSCHRIFT

(11) **EP 0 984 292 B1**
(45) Veröffentlichungstag und Bekanntmachung des Hinweises auf die Patenterteilung: **21.02.2007**
(21) Anmeldenummer: 99116944.2
(22) Anmeldetag: 27.08.1999
(51) Int. Cl.: G01R 31/34, G01R 19/00, G01R 1/20

(54) **Srommessung in Pumpen**
Current measurements in pumps
Mesures de courant pour pompes

(30) Priorität: 04.09.1998 DE 19840479
(43) Veröffentlichungstag der Anmeldung: 08.03.2000
(73) Patentinhaber: Pierburg GmbH, 41460 Neuss (DE)
(72) Erfinder: Stephan, Waldemar, 44319 Dortmund (DE)
(74) Vertreter: COHAUSZ DAWIDOWICZ HANNIG & SOZIEN

(56) Entgegenhaltungen:
- DE-A- 19 537 495
- US-A- 4 032 766
- US-A- 4 369 354
- US-A- 4 584 525

## Beschreibung

Die Erfindung betrifft ein Verfahren zur Bestimmung der Stromaufnahme einer mittels einer Steuerelektronik geregelten Pumpe durch Messung des Spannungsabfalls über einem in der Pumpe befindlichen Widerstandselement. Die Erfindung betrifft zudem eine Pumpe, die zur Durchführung des Verfahrens geeignet ist.

Derartige Verfahren sind bekannt. Beispielsweise offenbart die deutsche Offenlegungsschrift DE 195 37 495 eine Vorrichtung zur Überwachung der Stromaufnahme eines elektrischen Verbrauchers, beispielsweise eines Motors, in dessen Zuleitungskabel eine Schmelzsicherung eingebracht ist, welche als Widerstandselement fungiert, an dem der auftretende Spannungsabfall bei Bestromung des Motors durch eine Messschaltung abgegriffen und daraus die Stromaufnahme des elektrischen Verbrauchers ermittelt wird.

Die Funktion von Elektromotoren insbesondere von Pumpen, wie z.B. von elektronisch geregelten Kreiselpumpen, kann durch die Messung von Betriebsparametern wie des Stromes, den der Motor aufnimmt, überwacht werden. Dabei deutet eine Erhöhung des Stromflusses auf eine höhere Belastung der Pumpe hin, so dass beispielsweise eine Überlastung festgestellt und die Pumpe nach Art eines Notstopps abgeschaltet werden kann. Neben dieser Schutzfunktion bietet eine Strommessung darüberhinaus die Möglichkeit, die Drehzahl der Pumpe zu regeln.

Ein derartiges Verfahren ist beispielsweise aus dem deutschen Gebrauchsmuster DE 90 13 486.9 U1 bekannt, welches die Leistungsregelung eines Elektromotors bei einem Hochdruckreinigungsgerät zum Gegenstand hat. Die Leistungsregelung macht sich hierbei den physikalischen Zusammenhang zu nutze, dass der Druck der von der Pumpe abgegebenen Flüssigkeit direkt proportional zum Drehmoment des Motors ist, welches wiederum direkt proportional zum aufgenommenen Strom des Motors ist. Der aufgenommene Strom des Elektromotors dient daher bei der Regelung als direktes Maß für den Ausgangsdruck der Pumpe. Durch die Messung der Stromaufnahme des antreibenden Elektromotors, die nicht näher erläutert wird, kann daher eine Regelung des Drucks des Hochdruckreinigers derart erfolgen, dass ein gemessener Istwert mit einem vorgegebenen Sollwert verglichen und aufgrund der Differenz dieser beiden Werte eine regelungstechnische Maßnahme zur Einstellung des gewünschten Solldrucks erfolgt.

Wie bekannt ist, wird die Strommessung als Spannungsabfall über einem definierten Wiederstand gemessen. Im Falle der elektronisch geregelten Pumpen ist ein solcher Messwiderstand innerhalb der Leistungselektronik angeordnet. Ein solcher Messwiderstand hat den Nachteil, dass er ein extra Bauteil darstellt, welches als solches zusätzliche Kosten verursacht und zudem in einem separaten Schritt im Fertigungsprozeß eingelötet werden muß. Gerade im Hinblich auf die zunehmende Rationalisierung bei der Fertigung immer einfacherer und billigerer Pumpen spielen die Aufwendungen für den Messwiderstand und dessen Einbau eine ernstzunehmende Rolle.

Weiterhin ist es von Nachteil, dass der Messwiderstand Leistung verbraucht, die einerseits zur unerwünschten Erwärmung der Elektronik beiträgt und die andererseits beim Dauerbetrieb der Pumpe als Kostenfaktor für den Kunden ins Gewicht fällt und ihn mit einer höheren Stromrechnung belastet.

Aus der amerikanischen Patentschrift US 4,584,525 ist eine Vorrichtung zur Messung des in einer Leitung fließenden Stromes bekannt, bei der als Widerstandselement die Kupferleitung innerhalb des elektrischen Leiters selbst dient. Die Vorrichtung umfasst hier zwei spitze Messspitzen, die zueinander beabstandet sind und durch die isolierende Kunststoffummantelung des elektrischen Leiters gestoßen werden, um den inneren metallischen Leiter zu kontaktieren. Es wird damit eine universale, auf viele Leitertypen, beispielsweise aus Kupfer oder Aluminium, beliebigen Durchmessers anwendbare Strommesseinrichtung bereitgestellt, die beispielsweise in einem Handmessgerät eingesetzt werden kann. Mit Hilfe von Schaltern kann der Messbereich in Abhängigkeit des gewählten elektrischen Leiters eingestellt werden.

Aufgabe der Erfindung ist es daher, ein Verfahren zur Strommessung zu schaffen, das bei hoher Genauigkeit der Messergebnisse zu einer Vereinfachung der Pumpe und damit zur Minimierung der Herstellungs- und Betriebskosten der Pumpe beiträgt. Gleichzeitig ist es Aufgabe der Erfindung, eine für die Anwendung des Verfahrens geeignete Pumpe zu schaffen.

Diese Aufgaben werden durch das Verfahren nach Anspruch 1 und die Pumpe nach Anspruch 3 gelöst.

Dadurch, dass das erfindungsgemäße Verfahren ein Stück einer Verbindungsleitung zwischen der Steuerelektronik und der Versorgungsspannung und kein in die Pumpe einzulötendes separates Bauteil (Messwiderstand) für die Messung des Stromes nutzt, werden zunächst Herstellungskosten gespart. Bei einer kleinen Heizungspumpe kann es sich dabei durchaus um eine Ersparnis von etwa 2.0% handeln, wenn auf den extra Widerstand verzichtet wird und stattdessen auf ein Stück des sowieso vorhandenen Verbindungsdrahtes zurückgegriffen wird. Dabei ist es selbstverständlich, dass der Widerstand des zur Messung verwendeten Drahtstückchens bekannt ist. Die Verwendung des Verbindungsdrahtes macht den Einbau des Messwiderstandes überflüssig und vereinfacht somit die Herstellung.

Durch die Verwendung der Verbindungsleitung wird die Zuverlässigkeit der Messung und damit die Zuverlässigkeit der Pumpe insofern erhöht, als dass auf ein Bauteil, das eine Fehlerquelle darstellen kann, verzichtet wird. Der Verzicht auf den Messwiderstand bedeutet darüberhinaus den Verzicht auf einen unnötigen Verbraucher, der den Wirkungsgrad der Pumpe belastet und zur ungewünschten Erwärmung der Pumpe bzw. der Elektronik beiträgt. Gleichzeitig kann der Bauraum der Elektronik und damit die Abmessungen der Pumpe verringert werden, was besonders im Hinblick auf den Einsatz der Pumpe unter beengten Verhältnissen von großem Vorteil ist. Die Minimierung des Bauraumes macht das erfindungsgemäße Verfahren für kleine Pumpen wie Kreiselpumpen insbesondere für den Einsatz in Heizkreisläufen besonders vorteilhaft.

Eine besonders genaue Strommessung ist möglich, wenn eine Recheneinheit, z.B. der in der Steuerelektronik vorhandene Mikrocomputer die Berechnung des Stromaufnahme aus dem Wert des Spannungsabfalls über dem Stück der Verbindungsleitung bewerkstelligt. Ein solcher Mikrocomputer berechnet auf besonders einfache Weise den von der Pumpe aufgenommenen Strom aus dem Wert des von der Steuereinheit aufgenommenen Stromes. Dabei ist es vorteilhaft, Störfaktoren, wie das Temperaturverhalten der Verbindungsleitung oder die Einflüsse der Steuerelektronik auf den Spannungsabfall gesondert zu berücksichtigen und in die Berechnung mit einzubeziehen. Die Berücksichtigung solcher Störgrößen ist insofern unerläßlich, als nach dem erfindungsgemäßen Verfahren die Stromaufnahme der Pumpe, die im Wesentlichen der Stromaufnahme der Leistungselektronik entspricht, aus dem vergleichsweise kleinen Strom, der in die Steuerelektronik fließt, "indirekt" ermittelt wird.

Besonders vorteilhaft ist es, wenn das als Widerstandselement verwendete Stück der Verbindungsleitung aus Draht definierten Widerstandes insbesondere aus sogenanntem Widerstandsdraht, der sich durch einen bekannten spezifischen Widerstand auszeichnet, gefertigt ist. Dieser Widerstandsdraht braucht lediglich in bestimmter Länge abgeschnitten und in die Pumpe eingebaut zu werden. Da Widerstandsdraht innerhalb eines Temperaturbereiches ein vorhersehbares Verhalten zeigt, können seine Kenndaten der Recheneinheit als Datensatz oder als funktionale Abhängigkeit zur Verfügung gestellt und so einfach in der Berechnung des Stromes berücksichtigt werden.

In einer besonders vorteilhaften Ausführungsform wird das Leiterstück durch Bonden zwischen einem Steckkontakt, an dem die Versorgungsspannung anliegt, und einer Leiterplatte der Steuerelektronik aufgebracht. Der so aufgebrachte

Draht hat vorteilhafterweise einen Widerstand von etwa 1-5 mΩ.

Eine zur Umsetzung des erfindungsgemäßen Verfahrens geeignete Pumpe ist in den Zeichnungen 1, 2 und 3 dargestellt und wird im folgenden näher beschrieben. Es zeigen
- **Figur 1**: eine Kreiselpumpe,
- **Figur 2**: einen Bonddraht als Messwiderstand und
- **Figur 3**: das Schaltschema zur Strommessung.

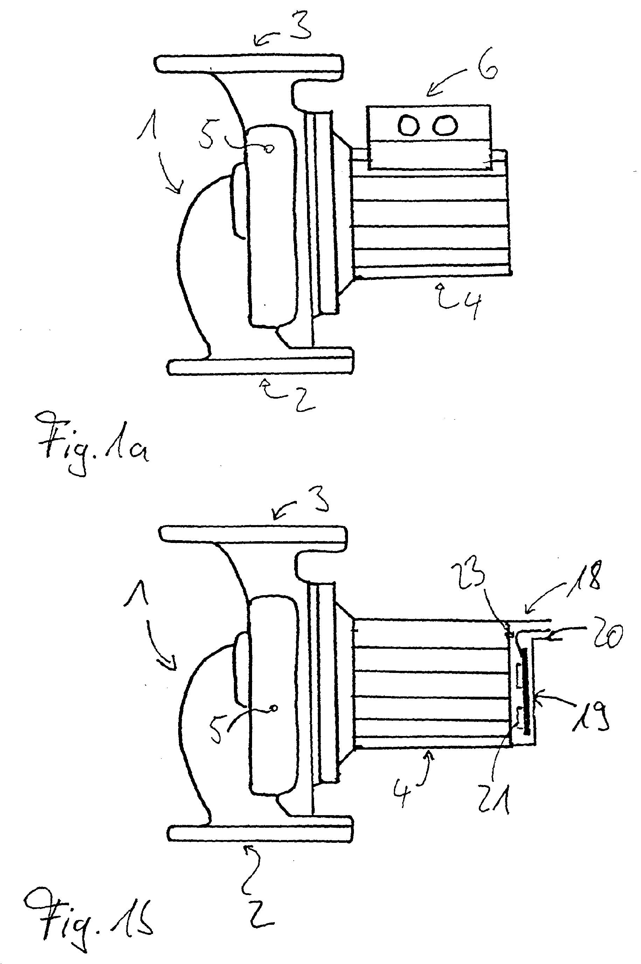

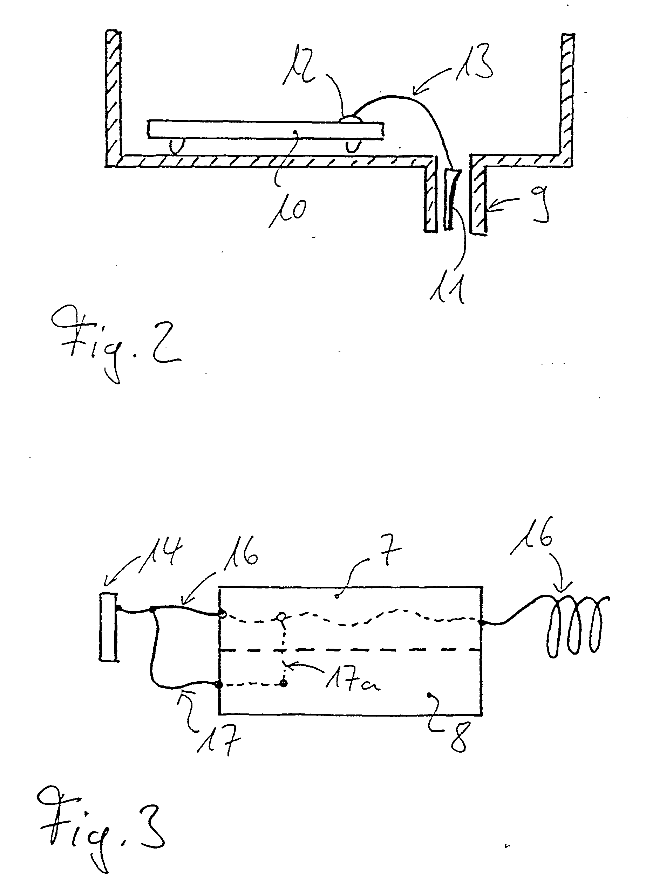

In der Figur 1a ist eine an sich bekannte Kreiselpumpe 1 für einen Heizwasserkreislauf mit Einlass 2 und Auslass 3 gezeigt. Die Pumpe 1 hat einen Elektromotor in einem Motorgehäuse 4, der ein in dem Gehäuse 5 befindliches Pumpenlaufrad antreibt. Der elektrische Anschluss der Pumpe 1 geschieht über einen Klemmenkasten 6, der auf dem Gehäuse des Motors 4 aufsitzt. Der Klemmenkasten 6 beinhaltet sowohl die Anschlüsse für die Leistungselektronik 7 als auch die Steuerelektronik 8 (Figur 3). Figur 1b zeigt eine Kreiselpumpe ohne Klemmenkasten mit einem Direktanschluß 18 am Motorgehäuse 4. Die Elektronik ist in diesem Falle in einem axial hinter dem Motorgehäuse 4 aufgesetzten Kasten 19 eingebaut, an den ein Stecker 20 zum Anschluß der Versorgungsspannung angeformt ist. In dem Kasten 19 sind die elektronischen Bauteile 21 auf einem Substrat aus Keramik oder einer Leiterplatte 22 aufgebracht. Die Verbindung von der Leiterplatte 22 zum Stecker 20 geschieht über einen Bonddraht 23.

Das Ausführungsbeispiel nach Figur 2 zeigt einen Schnitt durch den Klemmenkasten 6, der mit einem Fuß 9 auf das Gehäuse des Motors 4 aufsetzbar ist. In dem Klemmenkasten 6 ist eine Platine 10 der Steuerelektronik untergebracht. Die Platine 10 ist über einen Steckkontakt 11 mit den Wicklungen des Motors 4 verbunden. Zwischen dem Steckkontakt 11 und dem Anschlußkontakt 12 der Platine 10 stellt ein Draht 13, der durch das Verfahren des Bondens aufgebracht ist, den Kontakt her. Der Bonddraht 13 hat in diesem Fall einen Widerstand von 2-3 Milliohm und wird als Messwiderstand für die Strommessung benutzt.

Figur 3 zeigt das Schaltschema zur Strommessung in einer Pumpe. Ausgehend von dem Spannungsanschluß 14 wird die Leistungselektronik 7 über eine Versorgungsleitung 16 mit Strom versorgt. An die Leistungselektronik 7 ist die Wicklung 16 angeschlossen (unterbrochene Linie). Zur Steuerelektronik 8 führt eine Versorgungsleitung 17, die in diesem Falle aus Wiederstandsdraht besteht und den Messwiderstand darstellt (alternative Führung s. unterbrochene Linie 17a).

## Patentansprüche

1. Verfahren zur Bestimmung der Stromaufnahme einer mittels einer Steuerelektronik geregelten Pumpe (1), **dadurch gekennzeichnet, dass** ein Spannungsabfall über einem Stück einer Versorgungsleitung mit definiertem Widerstand zwischen der Steuerelektronik (8) und der Versorgungsspannung von einer Recheneinheit der Steuerelektronik gemessen und daraus die Stromaufnahme berechnet wird.

2. Verfahren nach einem der vorherigen Ansprüche, **dadurch gekennzeichnet, dass** mittels der Recheneinheit das Temperaturverhalten der Versorgungsleitung in die Berechnung der Stromaufnahme der Pumpe (1) einbezogen wird.

3. Elektronisch geregelte Pumpe mit einer Steuerelektronik zur Regelung, wobei die Steuerelektronik über eine Versorgungsleitung an eine Versorgungsspannung angeschlossen ist, **dadurch gekennzeichnet, dass** eine Recheneinheit der Steuerelektronik dazu eingerichtet ist, einen Spannungsabfall über einem Stück der genannten Versorgungsleitung zu messen und hieraus die Stromaufnahme zu berechnen, wobei das Leiterstück der Versorgungsleitung einen definierten Widerstand aufweist.

4. Pumpe nach Anspruch 3, **dadurch gekennzeichnet, dass** das Leiterstück ein Stück Widerstandsdraht mit bekanntem spezifischem Widerstand und definierter Länge ist.

5. Pumpe nach Anspruch 3, **dadurch gekennzeichnet, dass** das Leiterstück (23) ein durch Bonden zwischen einem Steckkontakt, an dem die Versorgungsspannung anliegt, und einer Leiterplatte (19) der Steuerelektronik (8) aufgebrachtes Drahtstück definierten Widerstandes ist.

6. Pumpe nach einem der Ansprüche 3 bis 5, **dadurch gekennzeichnet, dass** der Widerstand des Leiterstückes zwischen 1 und 5 mΩ beträgt.

7. Pumpe nach einem der Ansprüche 3 bis 6, **dadurch gekennzeichnet, dass** die Abhängigkeit des Widerstands des Leiterstückes von der Temperatur der Recheneinheit zur Verfügung stehen.

## Claims

1. Method for determining the current consumption of a pump (1) controlled by means of control electronics, **characterised in that** a voltage drop is measured by an arithmetic unit of the control electronics over a portion of a supply line of defined resistance between the control electronics (8) and the supply voltage, and the current consumption is calculated therefrom.

2. Method according to the preceding claim, **characterised in that** the temperature behaviour of the supply line is included by means of the arithmetic unit in the calculation of the current consumption of the pump (1).

3. Electronically controlled pump having control electronics for regulation thereof, the control electronics being connected via a supply line to a supply voltage, **characterised in that** an arithmetic unit of the control electronics is configured to measure a voltage drop over a portion of the aforementioned supply line and to calculate the current consumption therefrom, the conductive portion of the supply line having a defined resistance.

4. Pump according to claim 3, **characterised in that** the conductive portion is a portion of resistance wire of known specific resistance and defined length.

5. Pump according to claim 3, **characterised in that** the conductive portion (23) is a portion of wire of defined resistance attached by bonding between a connector contact to which the supply voltage is supplied and a printed circuit board (19) of the control electronics (8).

6. Pump according to any one of claims 3 to 5, **characterised in that** the resistance of the conductive portion is from 1 to 5 mΩ.

7. Pump according to any one of claims 3 to 6, **characterised in that** the dependence of the resistance of the conductive portion on temperature is available to the arithmetic unit.

## Revendications

1. Procédé de détermination de la consommation de courant d'une pompe (1) régulée au moyen d'une électronique de commande, **caractérisé en ce qu'**une chute de tension est mesurée à travers un élément d'une ligne d'alimentation de résistance définie entre l'électronique de commande (8) et la tension d'alimentation par une unité de calcul de l'électronique de commande et la consommation de courant en est calculée.

2. Procédé suivant l'une des revendications précédentes, **caractérisé en ce que** le comportement thermique de la ligne d'alimentation est pris en compte dans le calcul de la consommation de courant de la pompe (1) au moyen de l'unité de calcul.

3. Pompe à régulation électronique comprenant une électronique de commande pour la régulation, l'électronique de commande étant raccordée par l'intermédiaire d'une ligne d'alimentation à une tension d'alimentation, **caractérisée en ce qu'**une unité de calcul de l'électronique de commande est conçue pour mesurer une chute de tension à travers un élément de la ligne d'alimentation citée et pour en calculer la consommation de courant, l'élément conducteur de la ligne d'alimentation présentant une résistance définie.

4. Pompe suivant la revendication 3, **caractérisée en ce que** l'élément conducteur est un élément de fil de résistance de résistance spécifique connue et de longueur définie.

5. Pompe suivant la revendication 3, **caractérisée en ce que** l'élément conducteur (23) est un élément de fil de résistance définie, appliqué par métallisation entre un contact à fiches, sur lequel s'applique la tension d'alimentation, et une carte imprimée (19) de l'électronique de commande (8).

6. Pompe suivant l'une des revendications 3 à 5, **caractérisée en ce que** la résistance de l'élément conducteur est comprise entre 1 et 5 mΩ.

7. Pompe suivant l'une des revendications 3 à 6, **caractérisée en ce que** la relation entre la résistance de l'élément conducteur et la température est fournie à l'unité de calcul.
